# EUROPEAN PATENT APPLICATION

(11) **EP 4 794 476 A1**
(43) Date of publication of application: **19.08.2026**
(21) Application number: 26315054.2
(22) Date of filing: 12.02.2026
(51) Int. Cl.: H10D 64/27, H10D 12/00, H10D 12/01

(54) **METHOD OF FORMING A RECESSED GATE TERMINAL, AND WAFER INCLUDING THE RECESSED GATE TERMINAL AND HAVING REDUCED WARPAGE**

(30) Priority: 18.02.2025 IT 202500003174
(71) Applicant: STMicroelectronics International N.V., 1228 Plan-les-Ouates, Geneva (CH)
(72) Inventor: Mariani, Simone Dario, 20864 Agrate Brianza (MB) (IT); Thomas-Boutherin, Isabelle, 38700 La Tronche (FR); Fagiani, Davide, 20864 Agrate Brianza (MB) (IT); Pistoni, Mario Francesco, 20864 Agrate Brianza (MB) (IT); Isacchi, Manuel, 20864 Agrate Brianza (MB) (IT); Bouvier, Julien, 38100 Grenoble (FR)
(74) Representative: Studio Torta S.p.A.

(57) **Abstract**

The proposed solution is designed for IGBT and discrete devices with vertical gate; the proposed method includes: trench formation, including lithography and etching, in a wafer; oxidation to grow gate dielectric; polysilicon filling with a thin layer to form first gate conductive layer; a second dielectric deposition and recession to fill half of the trench from the bottom up to a fixed depth; trench filling with polysilicon to form a second gate conductive layer. The second dielectric can be chosen with a dedicated stress and a dedicated recession, to counterbalance the polysilicon stress and reduce wafer warpage.

## Description

### TECHNICAL FIELD

The present invention relates to a method of forming a trench-gate terminal of an electronic device and a wafer or die including the trench-gate terminal.

### STATE OF THE ART

IGBTs (Insulated-Gate Bipolar Transistors), AS WELL AS and other discrete devices with vertical conductive channel, typically use a trench-based design for the gate region or terminal. The bottom and lateral walls of the trenches are usually covered with an oxide layer having substantially uniform thickness, and the trench is then filled with polysilicon, so that the polysilicon is isolated from the substrate by the oxide layer. The oxide is the gate dielectric and the polysilicon is the gate conductive plate.

Trenches often cover most of the die area, providing a high Mask Transmission Factor (around 30%) for the corresponding mask level. The Mask Transmission Factor is the percentage of the mask where the photoresist is removed, corresponding to the area where the trenches are etched.

Give the relatively high coverage of the die area, the gate oxide and, more in particular, the polysilicon, generate a stress that causes, during manufacturing, wafer deformation; moreover, the deformation is usually asymmetrical (in top-side view, the wafer deformation along orthogonal directions, X-Y, is not symmetrical). The manufacturing tools used to handle and process the wafers have a limited capacity to manage deformed wafers.

Furthermore, for wafers of about 300 mm of diameter (or even 200mm or lower), the bow is worsened by geometrical factors, while the bow acceptance range of manufacturing tools remains almost unchanged; handling problems and the risks of scrapping wafers and/or damaging the tools are higher.

In the art known to the Applicant, warpage or bowing can be managed by dividing the polysilicon deposition into a plurality of deposition steps, with a thermal treatment after each deposition step (typically an RTP). A warpage or bowing compensation can also include a dedicated layer deposition at the backside of the wafer, to counterbalance the stress.

However, these solutions have some drawbacks, including for example the necessity of multiple polysilicon depositions and thermal treatments, which cause increased manufacturing costs and slower the manufacturing process. Moreover, the deposition of a backside layer requires dedicated tools, and the deposited backside layer typically suffers during high thermal budgets. Moreover, the latter solution does not address the issue of asymmetrical warpage or bowing along X and Y directions.

Patent application US2019/027564 A1 relates to semiconductor manufacturing technology, and particularly relates to a trench gate lead-out structure, and relates to a method of manufacturing a trench gate lead-out structure.

Patent application US2007/284657 A1 relates to a semiconductor device such as a vertical MOS field effect transistor (MOSFET) having a trench-type gate and an insulating gate bipolar transistor (IGBT) and its manufacturing method.

Patent application US2006/049453 A1 relates to a vertical insulated gate transistor and method for manufacturing it.

However, the above-mentioned issues are not solved. In fact, the prior art focuses on optimizing trench structures for purely electrical purposes, such as managing gate resistance or gate-to-drain capacitance.

For the above reasons, there is the need of providing alternative approaches of trench manufacturing that minimize the generated stress and specifically that addresses the mechanical problem of wafer warpage.

### SUMMARY

According to the present invention, a method of forming a gate terminal of an electronic device and a wafer or die including the gate are provided, as defined in the annexed claims.

### BRIEF DESCRIPTION OF THE DRAWINGS

For a better understanding of the present invention, preferred embodiments thereof will now be described purely by way of non-limiting example with reference to the appended drawings, wherein:
- Figures 1A-1F illustrate, in lateral view, process steps to manufacture a trench according to an aspect of the present invention; and
- Figure 2 illustrates, by means of a flow chart, process steps of Figures 1A-1F.

### DESCRIPTION OF PREFERRED EMBODIMENTS OF THE INVENTION

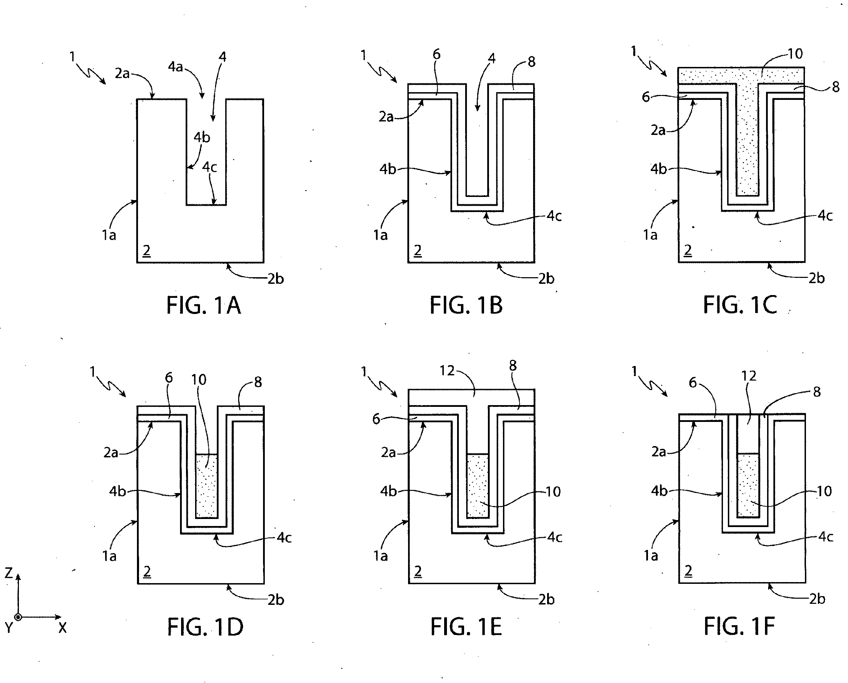

Figures 1A-1F show, in lateral view, a portion 1a of a wafer or a die 1, limited to the features useful to understand the present invention. The view of figures 1A-1F is in a triaxial coordinate system of mutually orthogonal axes X, Y, Z. The wafer has, in one example, a 300 mm diameter. The wafer may also be of 200 mm of diameter, or even lower diameter according to the manufacturing technology..

With reference to Figure 1A, the die 1 comprises a solid body 2 of semiconductor material; for example the solid body 2 is a semiconductor substrate; alternatively the solid body 2 comprises a semiconductor substrate over which one or more epitaxial layers are grown. The semiconductor material is or includes, for example, silicon or silicon carbide.

The solid body 2 comprises a first surface 2a and a second surface 2b. The first and the second surfaces 2a, 2b are, for example, parallel to the XY plane and delimit opposite surfaces of the solid body 2 (opposite to one another along the axis Z).

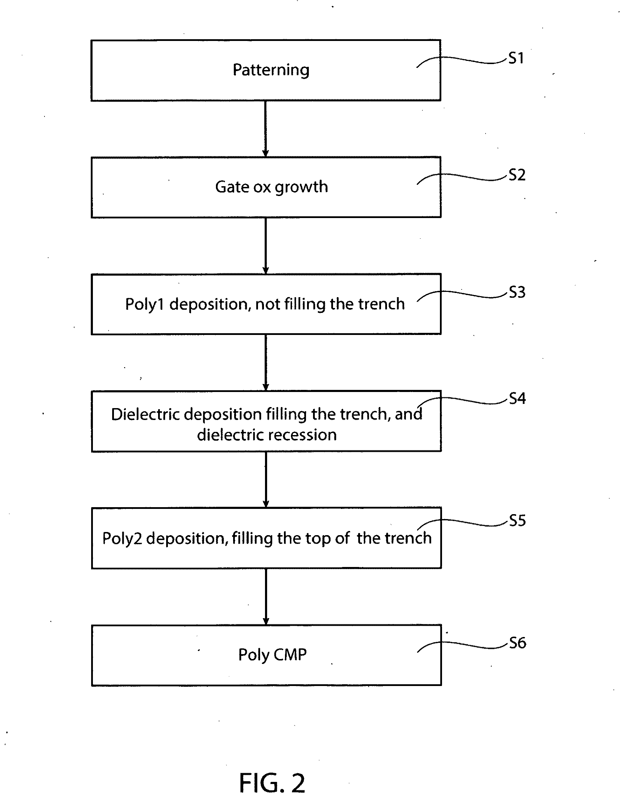

A trench 4 is formed (step S1 in Figure 2) in the solid body 2 at the first surface 2a towards the second surface 2b (along the direction of the axis Z), ending within the solid body 2 (without reaching the second surface 2b). The trench 4 can be formed by lithographic and etching techniques.

A front opening 4a of the trench 4 is coplanar with the first surface 2a. The trench 4 has a lateral wall 4b and a bottom wall 4c. The front opening 4a has, in top-plan view (on plane XY) a shape designed according to the needs, that is depending upon functional requirements. For example, the front opening 4a has, in top-plan view, an elongated shape substantially rectangular, with main dimension along the Y direction. The trench 4 has a depth, along the Z-axis direction, in the range 3-6 µm, for example between 4 and 5 µm. The trench 4 has a dimension, along the X-axis direction, in the range of 0.3-1.5 µm. The trench 4 has a dimension, along the Y-axis direction, for example comprised between 1 mm and 10 mm, in particular comprised between 2 mm and 6 mm.

With reference to Figure 1B and step S2 in Figure 2, a gate dielectric layer 6 is formed within the trench 4, covering the lateral wall 4b and the bottom wall 4c. In particular, the gate dielectric layer 6 uniformly covers the lateral wall 4b and the bottom wall 4c, with structural continuity. The gate dielectric layer 6 further extends on the first surface 2a of the solid body 2, laterally to the trench opening 4a. The gate dielectric layer 6 can be of any dielectric or electrically-insulating material, for example of silicon oxide (SiO₂). The gate dielectric layer 6 has a thickness in the range of 50-300nm (for example measured along the X direction at the lateral wall 4b, or along the Z direction at the bottom wall 4c). The gate dielectric layer 6 is for example deposited by CVD or is thermally grown by a corresponding thermal process.

Then, figure 1B and step S3 in Figure 2, a first gate conductive layer 8 is formed within the trench 4 on the gate dielectric layer 6. The first gate conductive layer 8 extends at the lateral wall 4b and bottom wall 4c of the trench 4 and is electrically insulated, and physically separated, from the lateral and bottom walls 4b, 4c of the trench 4 by the gate dielectric layer 6. The first gate conductive layer 8 extends with physical and structural continuity on the gate dielectric layer 6 and has a thickness in the range 50-400nm (for example measured along the X direction at the lateral wall 4b, or along the Z direction at the bottom wall 4c). The first gate conductive layer 8 is for example of polysilicon material, with a concentration of dopant species comprised between 1x10¹⁹ at/cm³ and 1x10²¹ at/cm³.

Optionally, the first gate conductive layer 8 further extends on the first surface 2a, laterally to the trench opening 4a and on the gate dielectric layer 4.

It is noted that the first gate conductive layer 8 does not completely fill the trench 4, but leaves an empty space within the trench 4.

With reference to Figure 1C and step S4 of Figure 2, the trench 4 is filled with a dielectric or insulating material (for example, silicon oxide, SiO₂, or silicon nitride, SiN or Si₃N₄, or a combination of silicon oxide and silicon nitride), forming a filling layer 10. The filling layer 10 is formed on the first gate conductive layer 8 and completely fills the trench 4. Optionally, the filling layer 10 further extends above the first surface 2a of the solid body, laterally to the trench 4. The filling layer 10 is formed by depositing the dielectric or insulating material with sputtering or CVD techniques, or other techniques available in the art.

Then, Figure 1D and step S4 of Figure 2, a step is carried out to partially etch the filling layer 10, thus removing the filling layer 10 from part of the trench 4 and, when present, from above the first surface 2a. The etching step is for example carried out through a wet etching solution (wet etching, for example including HF in case of SiO₂ or H₃PO₄ in case of SiN/Si₃N₄) or alternatively is carried out by dry etching techniques. The etching is, for example, of isotropic type. The filling layer 10 is removed from the trench 4 starting from the front opening 4a and proceeds towards the Z·axis until a certain depth is reached, for example to remove the filling layer 10 up to, or less than, half of the depth of the trench. In other terms, after the etching is completed, the filling layer 10 remains in the trench 4 at the bottom wall 4c and uniformly fills part of the trench 4 above the bottom wall 4c. In general terms, the filling layer 10 fills a percentage ranging from 40% to 80% (more particularly from 50% to 70%) of the empty space that the trench 4 has in the process step of Figure 2 (i.e., after formation of the first gate conductive layer 8).

In one embodiment, the filling layer 10 uniformly fills at least half (50%), preferably 70-80%, of the trench 4, starting from the bottom wall 4c.

In particular, for all the embodiments disclosed, the filling layer 10 is uniform within the trench 4, meaning that there are no apertures or holes or buried cavities within the filling layer 10.

In one alternative embodiment, the formation of the filling layer 10 comprises depositing the dielectric or insulating material until the desired thickness of the filling layer 10 is reached within the trench, without performing the etching step for recessing the filling layer 10.

Then, Figure 1E and step S5 of Figure 2, a second gate conductive layer 12 is deposited within the trench 4, to completely fill the trench 4, above the filling layer 10. Optionally, the second gate conductive layer 12 further extends above the first surface 2a of the solid body 2, laterally to the trench opening 4a. The second gate conductive layer 12 is for example of polysilicon, N-type doped with a concentration of dopant species comprised between 1x10¹⁹ at/cm³ and 1x10²¹ at/cm³.

Then, figure 1F and step S6 of Figure 2, a polishing step (e.g., by CMP, Chemical Mechanical Polishing) is carried out to completely remove, when present, the portions of the first and the second gate conductive layers 8, 12 extending on the first surface 2a of the solid body 2. The second gate conductive layer 12 therefore fills the trench 4 above the filling layer 10 and, at the aperture 4a, is coplanar with the gate dielectric layer extending on the first surface 2a laterally to the trench opening 4a.

In one embodiment, the filling layer 10 has a dimension, along the Z axis, that is 1/5 of the empty space that the trench 4 has in the process step of Figure 2. In another embodiment, the filling layer 10 has a dimension, along the Z axis, that is 1/2 of the empty space that the trench 4 has in the process step of Figure 2. In another embodiment, the filling layer 10 has a dimension, along the Z axis, that is 1/1.25 of the empty space that the trench 4 has in the process step of Figure 2.

As an example, for a trench 4 having a dimension (at process step of Figure 1), along the Z axis, of about 4.7 µm, the filling layer 10 has a dimension, along the Z axis, ranging from 0.95 µm and 3.8 µm.

The present invention can be used to manufacture a recessed gate terminal of an electronic device with vertical conduction, i.e. with conductive channel mainly along the Z-axis direction. Such electronic device has, as known in the art, a source terminal at the first surface 2a and a drain terminal at the second surface 2b (or vice versa). The doping of the solid body 2 may be of N-type or P-type, according to the design of the device. Accordingly, also the doping type of the first and second polysilicon layers 8, 12 can be opposite from what previously described, based on the conductive type (N or P) of the conductive channel.

The electronic device is, for example, one among: MOS transistor IC,BCD,IGBT, HV and LV discretes, VI power.

From what has been described above, the advantages of the present invention emerge clearly.

In particular, wafer warpage or bowing is customizable by designing the filling layer 10 in terms of material and recession depth; moreover, the costs are reduced with respect to the know process steps.
Moreover, the formation of the filling layer 10 through a process of depositing and subsequently recessing the insulating material provides significant advantages. The final volume and height of the filling layer 10 are critical for counterbalancing the mechanical stress generated by the polysilicon conductive layers 8, 12. The recession step (for example, a timed wet or dry etch) allows for highlyprecise and repeatable control over this final volume. This enables the manufacturing process to be "tuned" to compensate for different levels of stress, which may vary depending on the thickness of the polysilicon or the density of the trenches on the wafer. The filling layer 10 is chosen not only for its dielectric properties but also for its intrinsic mechanical stress (e.g., tensile or compressive). Different materials like silicon oxide and silicon nitride possess different stress characteristics. The invention allows the manufacturer to select an optimal material for stress compensation and then use the well-controlled recession step to achieve the desired geometry. This decouples the choice of material from the difficulty of a partial deposition, providing greater process flexibility.

## Claims

1. A method of forming a trench-gate terminal of an electronic device, comprising the steps of:
- forming (S1), at a first side (2a) of a solid body (2), a trench (4), the trench extending from the first side (2a) towards a direction (Z);
- forming (S2), within the trench (4), a gate dielectric layer (4) that covers with structural continuity lateral and bottom walls (4b, 4c) of the trench (4);
- forming (S3), within the trench (4) and on the gate dielectric layer (4), a first gate conductive layer (8) that extends with structural continuity along the lateral wall (4b) up to the first surface;
- forming (S4), within the trench (4) and on the first gate conductive layer (8), a filling layer (10) that partially fills the trench (4) from the bottom wall (4c) towards the first side (2a); and
- forming (S5, S6), within the trench (4) and on the filling layer (10), a second gate conductive layer (12).

2. The method of claim 1, wherein the step of forming (S3) the first gate conductive layer (8) includes leaving an empty space within the trench above the first gate conductive layer (8), and wherein the step of forming (S4) includes:
forming (S4) said filling layer (10) by depositing an insulating material to fill said empty space; and
recessing the filling layer (10) such that it partially fills the trench (4) from the bottom wall (4c) towards the first side (2a).

3. The method of claim 1 or claim 2, wherein the second gate conductive layer (12) is formed in direct electrical contact with the first gate conductive layer (8) above the filling layer (10).

4. The method of anyone of the preceding claims, wherein the filling layer (10) is separated from the bottom wall (4c) of the trench exclusively by the first gate conductive layer (8) and the gate dielectric layer (4).

5. The method of anyone of the preceding claims, wherein the filling layer (10) fills from 40% to 80%, in particular from 50% to 80%, more in particular from 70% to 80%, of empty space left in the trench after the step of forming the first gate conductive layer (8).

6. The method of claim 5, wherein the filling layer (10) is uniform within the trench (4), such that the filling layer 10 is free from apertures, holes and buried cavities.

7. The method of anyone of claims 1-4, wherein, within the trench (4), the quantity of the filling layer (10) is one among: five times the quantity of the second gate conductive layer (12); two times the quantity of the second gate conductive layer (12); 1.25 times the quantity of the second gate conductive layer (12).

8. The method of anyone of the preceding claims, wherein the filling layer (10) is of silicon oxide or of silicon nitride or of a combination of silicon oxide and silicon nitride.

9. The method of anyone of the preceding claims, wherein the first and the second gate conductive layer (8, 12) are of doped polysilicon.

10. A wafer or die comprising:
- a solid body (2) having a first side (2a) and a second side (2b) opposite to one another along a direction (Z);
- a trench (4) extending in the solid body (2) from the first side (2a) towards the second side (2b), ending within the solid body (2);
- a gate dielectric layer (4) in the trench (4), covering with structural continuity lateral and bottom walls (4b, 4c) of the trench (4);
- a first gate conductive layer (8) in the trench (4) on the gate dielectric layer (4), extending with structural continuity along the lateral wall (4b) up to the first surface (2a);
- a filling layer (10) in the trench (4) on the first gate conductive layer (8), that partially fills the trench (4) from the bottom wall (4c) towards the first side (2a);
- a second gate conductive layer (12) in the trench (4) on the filling layer (10).

11. The wafer or die of claim 9, wherein the second gate conductive layer (12) is in direct electrical contact with the first gate conductive layer (8) above the filling layer (10).

12. The wafer or die of anyone of claims 9-10, wherein the second gate conductive layer (12) fills the trench (4) up to the first side (2a).

13. The wafer or die of anyone of claims 9-11, wherein the filling layer (10) is separated from the bottom wall (4c) of the trench exclusively by the first gate conductive layer (8) and the gate dielectric layer (4).

14. The wafer or die of anyone of claims 9-12, wherein, in the trench (4), the proportion of the amount of the filling layer (10) with respect to the second gate conductive layer (12) is in the range from 40% to 80%, in particular from 50% to 80%, more particularly from 70% to 80%.

15. The method of claim 14, wherein the filling layer (10) is uniform within the trench (4), such that the filling layer 10 is free from apertures, holes, and buried cavities.

16. The wafer or die of anyone of claims 10-15, wherein at least one of:
the filling layer (10) is of silicon nitride, or of silicon oxide, or of a combination of silicon oxide and silicon nitride; and
the first and the second gate conductive layer (8, 12) are of doped polysilicon.
